# EUROPEAN PATENT APPLICATION

(11) **EP 1 717 562 A1**
(43) Date of publication of application: **02.11.2006**
(21) Application number: 05009426.7
(22) Date of filing: 29.04.2005
(51) Int. Cl.: G01F 15/14, G01F 15/18, G01F 1/34, H01L 21/50, G01L 9/00, G01L 19/14, G01N 21/00, G01N 27/00

(54) **A method for packaging integrated sensors**

(71) Applicant: Sensirion AG, 8712 Stäfa (CH)
(72) Inventor: Mayer, Felix, 8712 Stäfa (CH)
(74) Representative: Blum, Rudolf Emil

(57) **Abstract**

A sensor (2) integrated on a substrate (1) is packaged in a housing (10) by transfer molding. After demolding, an access opening (12) is drilled in housing (10) for connecting the sensor (2) to its surroundings. A buffer structure (6) can be placed adjacent to said sensor prior to casting, said buffer structure preventing said material from entering a volume adjacent to said sensor. This method simplifies the manufacturing process because it allows the use of standard molding technologies used for generic semiconductor packaging.

## Description

### Technical Field

The present invention relates to a method for packaging a sensor integrated on a substrate, in particular using molding techniques.

### Background Art

The integration of sensors on a substrate, e.g. a semiconductor substrate, provides a series of advantages, such as small size and the possibility to apply advanced manufacturing techniques as used in semiconductor technology. In addition, when using a semiconductor substrate, it is possible to integrate further functionality on the substrate, such as amplifiers, D/A-converters, calibration circuitry, etc.

Many of the sensors of this type, such as gas sensors, flow sensors, humidity sensors or optical sensors, need to be in contact with their surroundings, which makes it impossible to use conventional semiconductor packaging for housing the devices. Rather, specialized packaging techniques are required, such as they are e.g. described in US 6 750 522 or US 6 729 181. These packaging techniques tend, however, to be expensive.

### Disclosure of the Invention

Hence, it is a general object of the invention to provide an economical packaging technique for sensors of this type.

This object is achieved by the method of claim 1. Accordingly, a hardening material is cast over the sensor and its substrate. The material is hardened at least partially. Then the hardened material is removed locally for creating at least one access opening to the sensor in its housing. This procedure allows to use conventional, simple casting technology for housing the sensor with merely a post processing step for forming the access opening.

Advantageously, transfer molding or injection molding is used for casting the housing. This technique is widely applied in semiconductor packaging and therefore efficient and inexpensive. The post processing step for forming the access opening makes conventional semiconductor packaging applicable to sensor housing purposes.

In a particularly advantageous embodiment, a buffer structure is provided and placed at the sensor prior to casting. The buffer structure prevents the housing material from entering a volume adjacent to the sensor. The access opening is formed by removing the hardened material between the surface of the housing and the buffer structure. This simplifies the formation of the access opening because it renders it unnecessary to remove the material all the way to the sensor.

### Brief Description of the Drawings

The invention will be better understood and objects other than those set forth above will become apparent when consideration is given to the following detailed description thereof. Such description makes reference to the annexed drawings, wherein:
Fig. 1 shows a semiconductor substrate with integrated sensor,
Fig. 2 shows the device of Fig. 1 after the addition of the buffer structure,
Fig. 3 shows the device of Fig. 2 after placement on a lead frame,
Fig. 4 shows the device of Fig. 3 after transfer molding,
Fig. 5 shows the device of Fig. 4 after forming the access opening,
Fig. 6 shows a sectional view through the housing of the device of Fig. 5,
Fig. 7 shows second embodiment of the device,
Fig. 8 shows a flow sensor using the technology,
Fig. 9 shows another embodiment of a flow device,
Fig. 10 shows a pressure sensor,
Fig. 11 shows a further embodiment of the device, and
Fig. 12 shows yet another embodiment of the device, this one with a recessed housing.

### Modes for Carrying Out the Invention

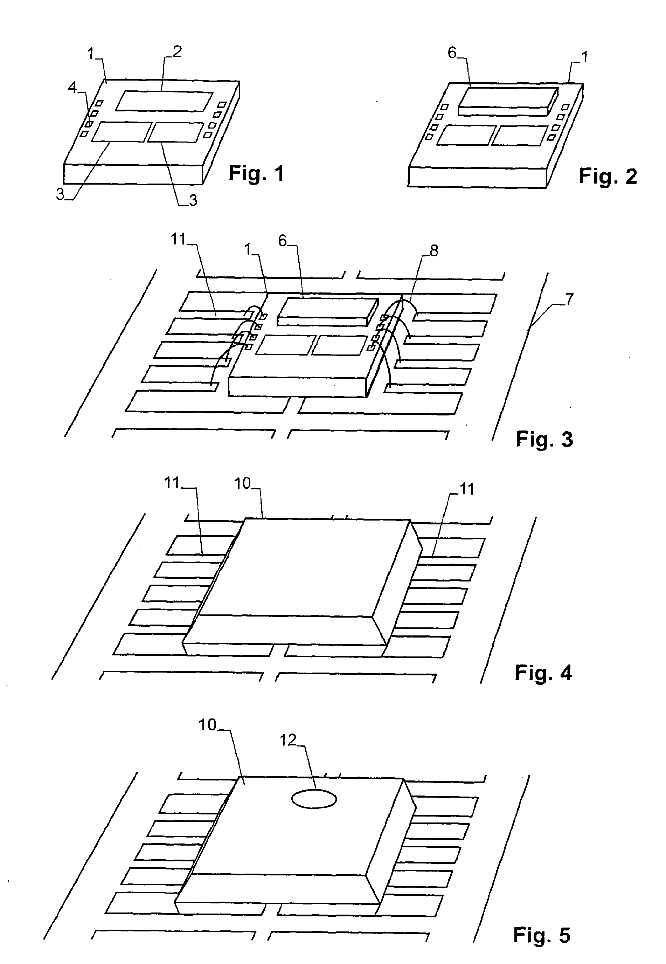

Figure 1 shows a device comprising a semiconductor substrate 1. A sensor 2, evaluation circuitry 3 and contact pads 4 are integrated on the top of the semiconductor substrate. Alternatively, substrate 1 can be a simple carrier for sensor 2, in which case it may also be of a non-semiconductor material.

The sensor of Fig. 1 may e.g. be a flow sensor, such as it is described in reference to Fig. 5 of US 6 729 181, in which case reference number 2 generally designates the membrane carrying the heater and temperature sensors. It may also be a sensor for detecting substances, in particular humidity, such as it is described in US 6 690 569, in which case reference number 2 generally designates the measuring layer of the device. The sensor may e.g. also be a light sensor, in which case reference number 2 generally designates the light sensitive area of the device, or it may be a pressure sensor, in which case reference number 2 generally designates a pressure sensitive area.

In the following, the steps for packaging the device of Fig. 1 in a housing are described.

In a first step, as shown in Fig. 2, a buffer structure 6 is placed adjacent to the sensor 2. As described in more detail below, buffer structure 6 may e.g. be a cap, a transparent plate or a porous body. Buffer structure 6 can e.g. be glued, bonded or soldered to substrate 1.

Now, as shown in Fig. 3, substrate 1 is placed on a lead frame 7. Lead frames are known to the person skilled in the art. They generally are metal structures that carry the substrate during packaging and that form the contact pins or pads of the final device. Bond wires 8 are used to connect the contact pads 4 to lead frame 7 in conventional manner.

In a next step, as shown in Fig. 4, a housing 10 is formed, advantageously by transfer molding or another molding technique. For this purpose, the device of Fig. 3 is placed in a suitable mold and a flowable material, such as a heated thermoplastic, is injected into the mold and then hardened. Finally the mold is removed. This technology is widely used for semiconductor packaging.

As can be seen from Fig. 4, housing 10 completely encloses substrate 1 and sensor 2. Contact sections 11 of lead frame 7 extend out of said housing for forming external contacts for the sensor after being separated from the other parts of the lead frame.

The sensor of the device of Fig. 4 will not be able to provide meaningful measurements because it is completely enclosed by housing 10. Therefore, as shown in Fig. 5, an access opening 12 is formed through the hardened material of housing 10. It extends from a surface of housing 10 into the volume of buffer structure 6.

Access opening 12 is advantageously formed by mechanical drilling, but it may also be formed using other techniques that allow to remove the material of housing 10 in the appropriate region, such as e.g. etching, local ablation, laser drilling, milling or cutting.

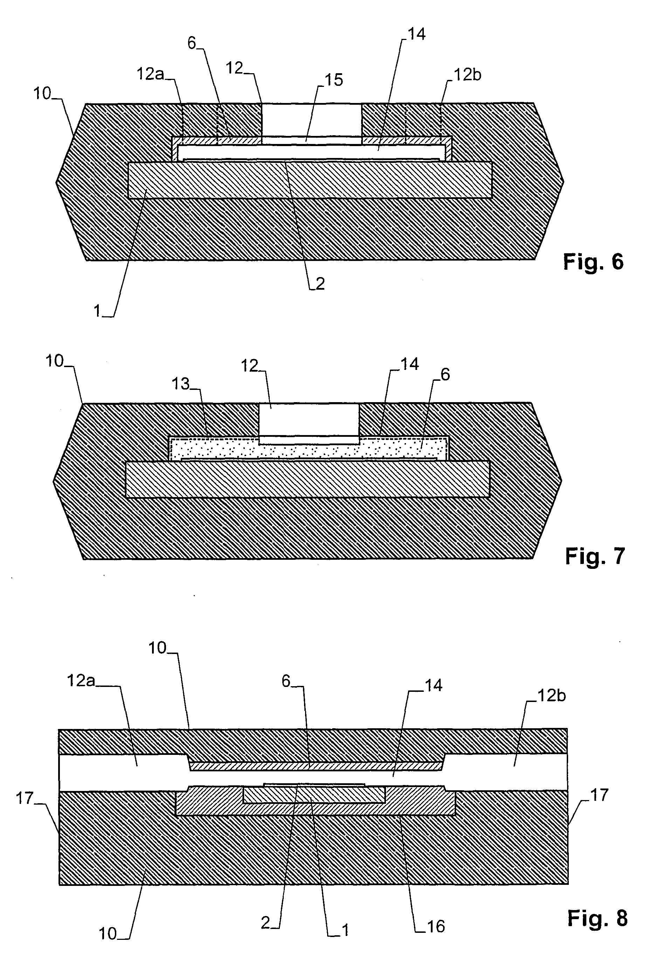

A sectional view through the housing of the final device is shown in Fig. 6. In particular, Fig. 6 shows the cap shaped buffer structure 6, which covers a cavity 14 above sensor 2. Since buffer structure 6 protects cavity 14 during casting, the material of housing 10 cannot enter cavity 14. Access opening 12 is drilled from the top side of the housing all the way to and into buffer structure 6, thereby not only removing the corresponding section of housing 10 but also a section 15 of buffer structure 6 for gaining access to cavity 14.

Once the drilling process (or any other access opening formation process) has pierced or removed the lid formed by buffer structure 6 over cavity 14, drilling is stopped before the drill reaches sensor 2, thereby avoiding damaging sensor 2.

As can be seen, access opening 12 allows sensor 2 to communicate with the surroundings.

Two other embodiments are now explained in reference to Fig. 7.

In a first of these embodiments, buffer structure 6 is made at least partially from a sacrificial material that can be removed after the formation of access opening 12. As shown in Fig. 7, access opening 12 is drilled into housing 10 to reach buffer structure 6. Then, buffer structure 6 is removed by heat and/or chemical treatment to release the volume that it occupied in order to form the cavity 14. A removal of buffer structure 6 can e.g. be achieved by one of the following means:
A) Buffer structure 6 is made of a material with a melting or evaporation temperature lower than the melting point of housing 10. For this purpose, housing 10 is cast using a polymer precursor or a partially polymerized material, which is then cured such that it withstands a higher temperature than the one required for melting or evaporating buffer structure 6. Once that housing 10 has been cured and access opening 12 has been formed, the device is subjected to a temperature sufficient for evaporating or melting buffer structure 6 at least partially. A suitable material for housing 10 is e.g. Xydar by Solvay Advanced Polymers, LCC, Georgia, USA, which can be cast as a resin at low temperatures. An advantageous material to be used for forming buffer structure 6 is the Unity Sacrificial Polymer by Promerus LCC, Cleveland, USA.
B) Buffer structure 6 is made of a material that can be solved or chemically decomposed after forming access opening 12. For example, buffer structure 6 can be made of a salt that can be dissolved by water introduced through access opening 12.

In a second embodiment with the set-up of Fig.7, buffer structure 6 is made of a material that is permeable for the parameter to be measured by sensor 2. In that case, there is no need to remove buffer structure 6 after forming access opening 6.

A typical example this type of embodiment is a housing for a sensor sensitive to electromagnetic radiation in a given spectral range. In that case, buffer structure 6 can be made at least partially of a material that is transparent over at least part of the given spectral range. If, for example, the sensor is a sensor for visible light, buffer structure 6 can comprise an acrylic, transparent lid.

Another typical example for this type of embodiment is a housing for a sensor for detecting a gas or the pressure of a gas, such as a humidity sensor or a differential or absolute pressure sensor. In this case, buffer structure 6 can be made at least partially of a material that is permeable for the gas. For example, buffer structure 6 can comprise a porous body, such as a permeable foam or porous ceramics.

When using a porous body, the same is advantageously covered by a protective layer prior to casting housing 10. This protective layer 13, as indicated by dashed lines in Fig. 7, prevents the material of the housing (which is liquid during casting) from entering the pores of the porous body. In that case, an opening must be created in protective layer 13 upon manufacturing access opening 12.

The present technique can also be used for packaging flow sensors.

In one embodiment, the design of Fig. 6 can be used for a flow sensor if two spaced apart access openings as indicated by dashed lines 12a, 12b, as indicated by dashed lines, are created instead of a single access opening 12. A first access opening 12a allows to feed the fluid to cavity 14, where its flow is measured, whereupon it exists through second access opening 12b.

A second embodiment of a flow sensor is shown in Fig. 8. In this embodiment, the access openings 12a, 12b are drilled in a direction parallel to the surface of sensor 2, thereby avoiding a bend in the flow channel to achieve a more laminar flow. The flow channel is formed by first access opening 12a, cavity 14 protected by buffer structure 6, and second access opening 12b.

To improve flow laminarity at the position of sensor 2, the substrate 1 of the embodiment of Fig. 8 has been embedded into a recess in a carrier plate 16, wherein the side of substrate 1 that carries sensor 2 is flush with a side of carrier plate 16.

As can be seen, the side surfaces 17 of the device of Fig. 8 are perpendicular to the access openings 12a, 12b, which makes it easier to connect the device to external ducts.

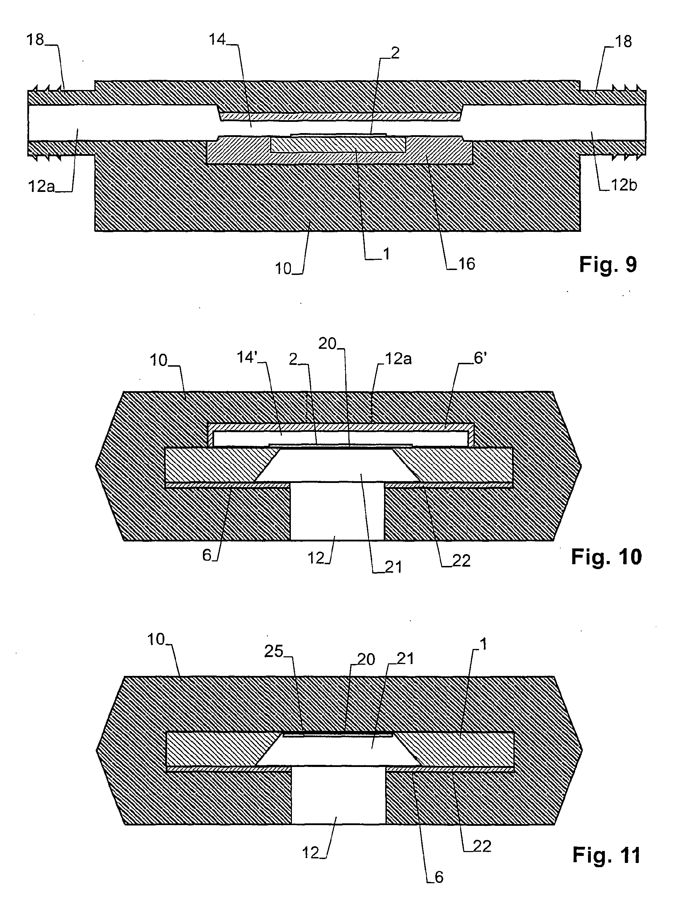

To further simplify the connection of a flow sensor of this design, the embodiment of Fig. 9 can be used, where sockets 18 have been formed in housing 10 during transfer molding. The access openings 12a, 12b extending from the sockets 18 to cavity 14 are again formed after demolding.

As mentioned, the process described here can also be used for pressure sensors. An embodiment for an absolute pressure sensor is shown in Fig. 10.

This embodiment uses a sensor comprising a thin membrane 20 extending over a recess 21 in substrate 1. Recess 21 extends from a side opposite to sensor 2 all the way through substrate 1. Buffer structure 6 comprises a plate 22 extending over recess 21 on the side opposite to sensor 2. An auxiliary buffer structure 6' having the shape of a cap is placed over membrane 20 opposite to buffer structure 6.

To connect the pressure sensor to its surroundings, an access opening 12 can be formed, as shown, from the bottom side of housing 10 through plate 22 into recess 21, thereby exposing the lower side of membrane 20 to a pressure to be measured. If an absolute pressure is to be measured, the cavity 14' enclosed by auxiliary buffer structure 6' remains closed, thereby forming a reference pressure reservoir to be measured against. Alternatively, recess 21 may remain closed and an access opening 12a as indicated by dashed lines could be formed from the upper side of housing 10 to extend through auxiliary buffer structure 6' into cavity 14'. For making a differential pressure sensor, both access openings 12 and 12' can be opened.

Fig. 11 shows yet another device using a substrate with a recess 21. In this embodiment, the sensor 2 is arranged at least partially within recess 21, e.g. by placing the moisture sensitive layer 25 of a humidity sensor at the bottom side of membrane 20. As in the embodiment of Fig. 10, buffer structure 6 comprises a plate 22 covering recess 21 and access opening 12 is drilled to extend through the bottom side of hosing 10 and through plate 22.

In both the embodiments of Figs. 10 and 11, plate 22 can be formed by a metal sheet of lead frame 7 or, preferably, by a separate plate placed at the bottom side of substrate 1 before placing substrate 1 onto lead frame 7. A separate plate is preferred because it prevents any glue used for attaching substrate 1 to lead frame 7 from entering recess 21.

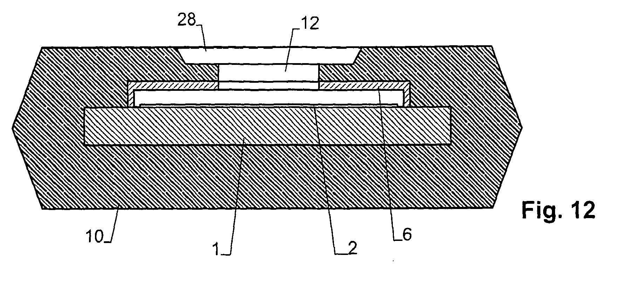

Yet another embodiment of a device is shown in Fig. 12. The shown embodiment substantially corresponds to the one of Fig. 6, with the difference that, during casting, a recess 28 has been formed in housing 10 at the future exit point of access opening 12. Hence, access opening 12 can be formed starting from this recess through a thinned wall section of housing 10, which allows faster manufacturing.

In the embodiments described so far, buffer structure 6 was used for protecting sensor 2 during casting and formation of access opening 12. However, depending on the robustness of the sensor and the process for creating access opening 12, buffer structure 6 may be omitted, or buffer structure 6 may be formed by an outermost layer of sensor 2.

## Claims

1. A method for packaging a sensor (2) integrated on a substrate (1), said method comprising the steps of
casting a housing (10) of a hardening material over said substrate (1) and said sensor (2),
hardening said material at least partially, and
removing the hardened material locally for creating at least one access opening (12, 12a, 12b) to said sensor (2) in said housing (10).

2. The method of claim 1 further comprising the steps of
placing the substrate (1) and the sensor (2) in a mold,
injecting the material into said mold, hardening the material,
removing the mold, and
after removing the mold, removing the hardened material locally for creating the access opening (12, 12a, 12b).

3. The method of any of the preceding claims further comprising the steps of
placing at least one buffer structure (6) adjacent to said sensor prior to casting, said buffer structure preventing said material from entering a volume adjacent to said sensor (2), and
removing the hardened material between a surface of said housing (10) and said buffer structure (6) for forming said access opening (12, 12a, 12b).

4. The method of claim 3 further comprising the step of removing or piercing said buffer structure (6) at least partially through said access opening (12, 12a, 12b).

5. The method of claim 4 further comprising the step of melting, evaporating, dissolving or chemically decomposing said buffer structure (6) at least partially for removing said buffer structure (6) at least partially through said access opening (12, 12a, 12b).

6. The method of any of the claims 3 to 5 wherein said buffer structure (6) maintains a cavity (14) in said volume during casting and wherein said access opening (12, 12a, 12b) is formed to extend into said cavity (14).

7. The method of any of the claims 3 to 6 wherein said buffer structure (6) comprises a plate (22) extending over a recess (21) in said substrate (1).

8. The method of any of the claims 3 to 7 wherein said buffer structure (6) comprises a cap and is located on said substrate (1) during molding.

9. The method of any of the claims 3 to 8 wherein said buffer structure (6) comprises a porous body, and in particular wherein the porous body is covered by a protective layer (13) for preventing flowable material of said housing (10) from entering pores of the porous body, wherein said protective layer is opened upon creating said access opening (12, 12a, 12b).

10. The method of any of the claims 3 to 9 wherein said sensor (2) is a flow sensor (2), and in particular wherein said method further comprising the step of forming two spaced apart access openings (12a, 12b) to said buffer structure (6), thereby forming a flow channel through a first of said access openings, said volume and a second of said access openings (12a, 12b).

11. The method of any of the claims 3 to 10 wherein said sensor (2) is a sensor (2) for electromagnetic radiation in a given spectral range, and in particular wherein said buffer structure (6) is transparent over at least part of said spectral range.

12. The method of any of the claims 3 to 11 wherein said sensor (2) is a pressure sensor (2), and in particular wherein at least two buffer structures (6, 6') are placed on opposite sides the sensor (2) and wherein said access opening (12, 12a, 12b) is formed to at least one of said buffer structures (6, 6').

13. The method of any of the preceding claims wherein the housing (10) is cast using transfer molding.

14. The method of any of the preceding claims comprising the step of, prior to casting said housing (10), mounting the substrate (1) on a metallic lead frame (7) and connecting contact pads (4) of the substrate (1) to said lead frame (7), wherein said housing (10) is cast such that said lead frame (7) is accessible from outside said housing (10) for forming external contacts for said sensor (2).

15. The method of any of the preceding claims wherein, during casting, a recess (28) is formed in said housing (10), wherein said access opening (12, 12a, 12b) is formed from said recess into said housing (10).
